# EUROPEAN PATENT APPLICATION

(11) **EP 4 478 860 A1**
(43) Date of publication of application: **18.12.2024**
(21) Application number: 23752384.0
(22) Date of filing: 08.02.2023
(51) Int. Cl.: H10K 30/50

(54) **LAMINATED SOLAR CELL AND APPLICATION THEREOF**

(30) Priority: 10.02.2022 CN 202210123990
(71) Applicant: Trina Solar Co., Ltd, Changzhou, Jiangsu 213031 (CN)
(72) Inventor: DING, Xiaobing, Changzhou, Jiangsu 213031 (CN); XIA, Rui, Changzhou, Jiangsu 213031 (CN); CHEN, Yiqi, Changzhou, Jiangsu 213031 (CN); LIU, Wei, Changzhou, Jiangsu 213031 (CN); ZHANG, Xueling, Changzhou, Jiangsu 213031 (CN); CHEN, Daming, Changzhou, Jiangsu 213031 (CN); CHEN, Yifeng, Changzhou, Jiangsu 213031 (CN)
(74) Representative: Nederlandsch Octrooibureau
(86) International application number: PCT/CN2023/075061
(87) International publication number: WO 2023/151604

(57) **Abstract**

The present application provides a laminated solar cell and an application thereof. The solar cell comprises a p-type silicon layer (1), connecting layers, a perovskite layer (2), and electrode layers; the connecting layers comprise a first connecting layer (3), a second connecting layer (4), and a third connecting layer (5); the electrode layers comprise a first electrode layer (6) and a second electrode layer (7); and in the direction moving away from the p-type silicon layer (1), the first connecting layer (3), the perovskite layer (2), the second connecting layer (4), and the first electrode layer (6) which are connected in sequence are provided on the front surface of the p-type silicon layer (1), and the third connecting layer (5) and the second electrode layer (7) which are connected in sequence are provided on the back surface of the p-type silicon layer (1). Compared with a single-junction cell, the efficiency of the laminated cell in the present application is remarkably improved, and production costs can be effectively reduced by selecting the p-type silicon layer (1) to form a laminated layer.

## Description

The present application claims the priority of a Chinese patent application filed with the Chinese Patent Office on February 10, 2022, with application number 202210123990.2 and the application name "laminated solar cell and application thereof", the entire contents of which are incorporated by reference in the present application.

### Technical Field

The present application mainly relates to the technical fields of the photovoltaic field and relates to a laminated solar cell and an application thereof.

### Background

Photovoltaic power generation is one of the most promising ways to provide the world with sustainable, clean, and low-cost energy. It is an effective means to reduce the total cost of photovoltaic power generation by improving the power conversion efficiency of modules per unit area. In recent years, perovskite materials have attracted significant attention from photovoltaic research due to their excellent optoelectronic properties and low preparation costs. Recently, perovskite/silicon laminated layer has rapidly developed into a new technology, and its reported photoelectric conversion efficiency has also exceeded the limit efficiency of crystalline silicon cells, while the theoretical efficiency can reach 44%, which is expected to become the next generation of new photovoltaic cell technology.

Based on perovskite/crystalline silicon laminated cells, its working principle is to use different bandgaps to absorb different sunlight spectrums, so as to improve the conversion efficiency of the cell, wide bandgap perovskite absorbs short-wavelength light, and long-wavelength light is transmitted to it for narrow bandgap silicon solar cells to absorb. At present, the bottom cell of laminated cells mainly use heterojunction formed by N-type silicon substrate, and the reported efficiency of perovskite/heterojunction laminated cell reaches 29.8%. At present, the photovoltaic industry has a large production capacity and low cost of p-type solar cells, and on this basis, laminating perovskite and p-type have obvious advantages.

Among the existing technical solutions, most of the research on laminated cells is based on n-type heterojunction cells, in which the thermal stability of interlayer hydride amorphous silicon directly limits the top perovskite, which accounts for only a small part of the solar energy market, and p-type c-Si solar cells have occupied more than 90% of the global market share in the past few decades.

The prior art discloses a novel laminated solar cell based on perovskite and crystalline silicon back-passivation and its manufacturing method, comprising a bottom cell and a top-layer cell, the upper electrode is fixedly connected to the top-layer cell, an intermediate layer is arranged between the bottom-layer cell and the top-layer cell, and the bottom-layer cell is a crystalline silicon back-passivated cell, wherein the crystalline silicon back-passivated cell comprises an n-type polycrystalline silicon film, a tunneling silicon oxide film, a p-type silicon matrix, a back-passivated layer and a metal lower electrode connected in sequence, and laminating the N-type silicon and perovskite has a higher cost and is not suitable for low-cost large-scale production.

Another prior art discloses a perovskite/crystalline silicon laminated cell and its preparation method, which includes a perovskite top cell and a tunneling oxide passivation contact silicon bottom cell, and directly forms a tunneling junction of the laminated cell through the n-type doped polysilicon of the TOPCon cell and the hole transport layer of the perovskite cell. Another prior art discloses an N-type TOPCon cell with quantum well structure and its fabrication method, in which a P+-doped layer is superimposed on an n-type silicon substrate, but the front side of the N-type TOPCon bottom cell is the p-type doped region, and there are many surface defects of the cell, so the perovskite connected in series on the front side will cause efficiency loss.

How to prepare a low-cost, large-scale, high-efficiency solar cell is an important research direction in this field.

### Summary

The purpose of the present application is to provide a low-cost, large-scale, high-efficiency laminated solar cell and an application thereof.

In order to achieve the purpose of this application, the application adopts the following technical scheme:
One of the purposes of this application is to provide a laminated solar cell, wherein the solar cell comprises a p-type silicon layer, a connecting layer, a perovskite layer and an electrode layer, the connecting layer includes a first connecting layer, a second connecting layer and a third connecting layer, and the electrode layer include a first electrode layer and a second electrode layer.

Along a direction far away from the p-type silicon layer, a front side of the p-type silicon layer provides the first connecting layer, the perovskite layer, the second connecting layer and the first electrode layer connected in turn; and a back side of the p-type silicon layer provides the third connecting layer and the second electrode layer connected in turn.

Laminated solar cell is applied in this application, and the efficiency is significantly improved compared with single-junction cells, and p-type silicon layers are selected, which are cheaper than n-type silicon materials, and the use of p-type silicon materials to form laminated materials can effectively reduce production costs.

As an optional technical solution for the present application, the p-type silicon layer comprises p-type monocrystalline silicon and/or p-type polycrystalline silicon.

The resistivity of the p-type silicon layer is 0.0001~1000 ohm·cm, the resistivity of which can be 0.0001ohm·cm, 0.001ohm·cm, 0.005ohm·cm, 0.01ohm·cm, 0.05ohm·cm, 0.1ohm·m, 0.5ohm·cm, 10hm·cm, 100om·cm, 100ohm·cm, 200ohm·cm, 300ohm·cm, 400ohm·cm, 500ohm·cm, 600ohm·cm, 700ohm·cm, 800ohm·cm, 900ohm·cm or 1000ohm·cm and so on, however, this is not limited to the values listed, and other values not listed within the range of the values also apply.

The thickness of the p-type silicon layer is 1~500µm, the thickness of which can be 1µm, 10µm, 50µm, 100µm, 150µm, 200µm, 250µm, 300µm, 350µm, 400µm, 450µm or 500µm and so on, however, this is not limited to the values listed, and other values not listed within the range of the values also apply.

As an optional technical scheme for the present application, the material structure of the perovskite layer is a three-dimensional crystal structure.

As an optional technical solution for the present application, the material of the perovskite layer is ABX₃, wherein A comprises any one or at least two combinations of FA, MA, Cs or Rb, wherein typical but non-limiting examples of the combination include: combination of FA and MA, combination of MA and Cs, combination of Cs and Rb, combination of MA and Rb, etc., B comprises any one or at least two combinations of Pb, Sn or Sr, wherein typical but non-limiting examples of the combination include: combination of Pb and Sn, combination of Sn and Sr, or combination of Pb and Sr, etc., X includes any one or at least two combinations of Br, I or CI, wherein typical but non-limiting examples of the combination include: combination of Br and I, combination of I and CI, or combination of Br and CI, etc..

As an optional technical scheme for the present application, the thickness of the perovskite layer is 10~3000nm, the thickness of which can be 10nm, 100nm, 200nm, 300nm, 400nm, 500nm, 600nm, 700nm, 800nm, 900nm, 1000nm, 1100nm, 1200nm, 1300nm, 1400nm, 1500nm, 1600nm, 1700nm, 1800nm, 1900nm, 2000nm, 2100nm, 2200nm, 2300nm, 2400nm, 2500nm, 2600nm, 2700nm, 2800nm, 2900nm or 3000nm and so on, however, this is not limited to the values listed, and other values not listed within the range of the values also apply.

As an optional technical solution for the present application, the first connecting layer, the second connecting layer and the third connecting layer independently and respectively comprises an n-type layer and/or a p-type layer.

The p-type layer comprises a hole transport layer or a p-type polycrystalline silicon layer.

The n-type layer comprises an electron transport layer or an n-type polycrystalline silicon layer.

As an optional technical solution for the present application, a quantity of p-type layers & 1, wherein the quantity may be 1, 2, 3, 4, 5 or 6, etc., but is not limited to the numerical value enumerated, and other numerical values not enumerated within the numerical range are also applicable. A quantity of n-type layers & 1, wherein the quantity may be 1, 2, 3, 4, 5 or 6, etc., but is not limited to the numerical value enumerated, and other unenumerated numerical values within the numerical range shall also apply.

As an optional technical scheme for the present application, the material of the electron transport layer comprises any one or at least two combinations of SnO₂, TiO₂, ZnO, BaSnO₃, C₆₀, graphene or fullerene derivatives, wherein typical but non-limiting examples of the combination include: combination of SnO₂ and TiO₂, combination of TiO₂ and ZnO, combination of ZnO and BaSnO₃, combination of BaSnO₃ and C₆₀, combination of C₆₀ and graphene or combination of graphene and fullerene derivatives, etc..

The material of the hole transport layer comprises any one or at least two combinations of P₃HT, Spiro-meoTAD, PEDOT:PSS, Nickel oxide, PTAA, MoO₃, CuSCN, CuzO, CuI or Spiro-TTB, typical but non-limiting examples of the combination described in are: a combination of P₃HT and Spiro-meoTAD, a combination of Spiro-meoTAD and PEDOT:PSS, a combination of PEDOT:PSS and Nickel oxide, a combination of Nickel oxide and PTAA, a combination of PTAA and MoO₃, a combination of MoO₃ and CuSCN, a combination of CuSCN and CuzO, a combination of CuzO and CuI or a combination of CuI and Spiro-TTB.

As an optional technical scheme for the present application, the thickness of the electron transport layer is 1~1000nm, the thickness of which can be 50nm, 100nm, 150nm, 200nm, 250nm, 300nm, 350nm, 400nm, 450nm, 500nm, 550nm, 600nm, 650nm, 700nm, 750nm, 800nm, 850nm, 900nm, 950nm or 1000nm and so on, however, this is not limited to the values listed, and other values not listed within the range of the values also apply.

The thickness of the hole transport layer is 1~1000nm, the thickness of which can be 50nm, 100nm, 150nm, 200nm, 250nm, 300nm, 350nm, 400nm, 450nm, 500nm, 550nm, 600nm, 650nm, 700nm, 750nm, 800nm, 850nm, 900nm, 950nm or 1000nm and so on, however, this is not limited to the values listed, and other values not listed within the range of the values also apply.

A material of the n-type polycrystalline silicon layer comprises n-type polycrystalline silicon. A material of the p-type polycrystalline silicon layer comprises p-type polycrystalline silicon.

The thickness of the n-type polycrystalline silicon layer is 1~200nm, wherein the thickness can be 20nm, 40nm, 60nm, 80nm, 100nm, 120nm, 140nm, 160nm, 180nm or 200nm, but is not limited to the enumerated values, and other unlisted values within the numerical range are also applicable.

The thickness of the p-type polycrystalline silicon layer is 1~200nm, wherein the thickness can be 20nm, 40nm, 60nm, 80nm, 100nm, 120nm, 140nm, 160nm, 180nm or 200nm, but is not limited to the numerical values listed, and other unlisted numerical values within the numerical range are also applicable.

The n-type polysilicon in the present application adopts phosphorus-doped amorphous silicon to form polysilicon through high-temperature activation, and the p-type polysilicon adopts boron-doped amorphous silicon to form polysilicon after high-temperature activation.

As an optional technical scheme for the present application, the first connecting layer, the second connecting layer and the third connecting layer also independently and respectively comprises any one or at least two combinations of transparent conductive electrode layer, buffer layer, tunneling layer, passivation layer or anti-reflective layer, wherein typical but non-limiting examples of the combination include: the combination of transparent conductive electrode layer and buffer layer, the combination of buffer layer and tunneling layer, the combination of tunneling layer and passivation layer or the combination of passivation layer and anti-reflection layer, etc..

As an optional technical solution for the present application, the material of the transparent conductive electrode layer comprises any one or at least two combinations of ITO, IZO, AZO, BZO or silver nanowires, wherein typical but non-limiting examples of the combination are: the combinations of ITO and IZO, the combinations of IZO and AZO, the combinations of AZO and BZO, or the combinations of BZO and silver nanowires, etc., but not limited to the values listed, and other values not listed within the range of such values shall also apply.

As an optional technical scheme for the present application, the thickness of the transparent conductive electrode layer is 1~1000nm, wherein the thickness can be 50nm, 100nm, 150nm, 200nm, 250nm, 300nm, 350nm, 400nm, 450nm, 500nm, 550nm, 600nm, 650nm, 700nm, 750nm, 800nm, 850nm, 900nm, 950nm or 1000nm and so on, however, this is not limited to the values listed, and other values not listed within the range of the values also apply.

As an optional technical scheme for the present application, the material of the buffer layer comprises SnOz and/or MoO₃.

As an optional technical scheme for the present application, the thickness of the buffer layer is 1~1000nm, wherein the thickness can be 50nm, 100nm, 150nm, 200nm, 250nm, 300nm, 350nm, 400nm, 450nm, 500nm, 550nm, 600nm, 650nm, 700nm, 750nm, 800nm, 850nm, 900nm, 950nm or 1000nm and so on, however, this is not limited to the values listed, and other values not listed within the range of the values also apply.

As an optional technical scheme for the present application, the material of the tunneling layer comprises any one or at least two combinations of SiOz, nc-Si:H or nc-SiO₂, wherein typical but non-limiting examples of the combination include: a combination of SiOz and nc-Si:H, a combination of nc-Si:H and nc-SiOz or a combination of SiOz and nc-SiOz, etc.

As an optional technical scheme for the present application, the thickness of the tunneling layer is 1~100nm, wherein the thickness can be 10nm, 20nm, 30nm, 40nm, 50nm, 60nm, 70nm, 80nm, 90nm or 100nm, etc., but is not limited to the numerical value enumerated, and other unenumerated numerical values within the numerical range are also applicable.

The tunneling layer in the present application consists of at least one layer of a single substance or mixture and has the function of collecting and transmitting carriers.

As an optional technical scheme for the present application, the material of the passivation layer comprises any one or at least two combinations of PEAI, FPEAI, EDTA, PMMA, Al2O3, silicon nitride or silicon nitride, wherein typical but non-limiting examples of the combination include: a combination of PEAI and FPEAI, a combination of FPEAI and EDTA, a combination of EDTA and PMMA, a combination of PMMA and Al₂O₃, a combination of Al₂O₃ and silicon nitride or combination of silicon nitride and silicon nitride, etc..

The materials of the passivation layer in the present application independently include any one or at least two combinations of any one or at least two of the terminal functional groups such as -COOH, -OH, -NH₂, -SH, - CN, -SCN, etc. Typical but non-limiting examples of the combination include: the combination of -COOH and -OH, the combination of -OH and -NH₂, the combination of -NH₂ and -SH, the combination of -SH and -CN, or the combination of -CN and -SCN.

As an optional technical solution for the present application, the material of the anti-reflective layer comprises LiF and/or MgF₂.

As an optional technical scheme for the present application, the thickness of the anti-reflective layer is 1~500nm, wherein the thickness may be 50nm, 100nm, 150nm, 200nm, 250nm, 300nm, 350nm, 400nm, 450nm or 500nm, but is not limited to the numerical value enumerated, and other unlisted numerical values within the numerical range are also applicable.

As an optional technical solution for the present application, the material of the electrode layer comprises any one or at least two combinations of silver, aluminum, gold, copper, titanium, chromium, nickel or palladium, wherein typical but non-limiting examples of the combination include: a combination of silver and aluminum, a combination of aluminum and gold, a combination of gold and copper, a combination of copper and titanium, a combination of titanium and chromium, a combination of chromium and nickel or a combination of nickel and palladium, etc.

As an optional technical scheme for the present application, the thickness of the electrode layer is 1~1000nm, wherein the thickness may be 50nm, 100nm, 150nm, 200nm, 250nm, 300nm, 350nm, 400nm, 450nm, 500nm, 550nm, 600nm, 650nm, 700nm, 750nm, 800nm, 850nm, 900nm, 950nm or 1000nm and so on, however, this is not limited to the values listed, and other values not listed within the range of the values also apply.

In the present application, conventional technical means such as LPCVD method, spin coating method, thermal evaporation, magnetron sputtering and other conventional technical means are selected for the preparation of solar cells, and the methods used are all conventional means, which are not further limited here.

The second object of the present application is to provide an application of laminated solar cells as described in one of the purposes, and the laminated cells are applied in the photovoltaic field.

Compared with the prior art, the present application has the following beneficial effects:
(1) The solar cells prepared in the present application are compatible with the production process of the existing p-type solar cells.
(2) The present application has the advantages of low production equipment input and simple production process.
(3) The perovskite/p-type crystalline silicon laminated solar cells prepared in this application have lower production costs than N-type silicon/perovskite laminated solar cell.
(4) The solar cells prepared in the present application can solve the bottleneck problem of p-type silicon efficiency.

### Brief Description of the Drawings

Fig. 1 is a structural diagram of a laminated solar cell provided in a specific embodiment of the present application.
Fig. 2 is a structural diagram of a laminated solar cell in embodiment 1 of the present application.
Fig. 3 is a structural diagram of a laminated solar cell in embodiment 2 of the present application.

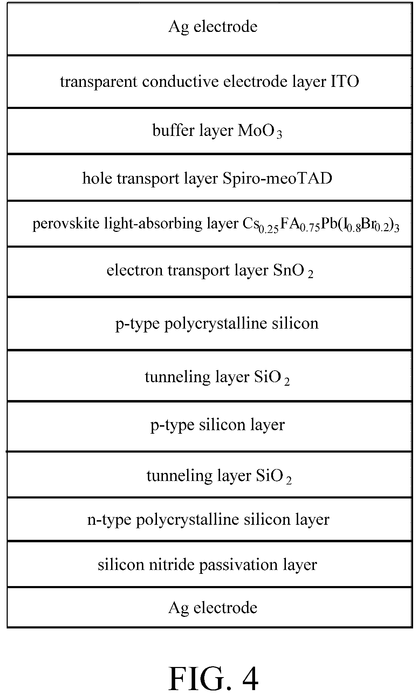

Fig. 4 is a structural diagram of a laminated solar cell in embodiment 3 of the present application.

In the drawings: 1-p-type silicon layer; 2-perovskite layer; 3- first connecting layer; 4- second connecting layer; 5- third connecting layer; 6- first electrode layer; 7 - second electrode layer.

### Preferred Embodiment of the Present Disclosure

The technical scheme of the present application is further described below by specific embodiments. Those skilled in the art should be aware that the said embodiments are merely to aid in understanding the present application and should not be regarded as a specific limitation of the present application.

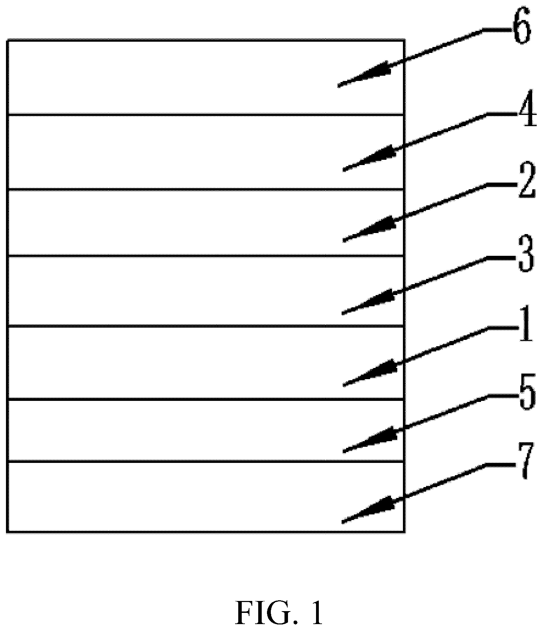

This application provides a laminated solar cell (as shown in Fig. 1), wherein the solar cell comprises a p-type silicon layer 1, a connecting layer, a perovskite layer 2 and an electrode layer, the connecting layer includes a first connecting layer 3, a second connecting layer 4 and a third connecting layer 5, and the electrode layer includes a first electrode layer 6 and a second electrode layer 7.

A front side of the p-type silicon layer 1 provides the first connecting layer 3, the perovskite layer 2, the second connecting layer 4 and the first electrode layer 5 connected in turn; and a back side of the p-type silicon layer 1 provides the third connecting layer 5 and the second electrode layer 7 connected in turn.

Laminated solar cell is applied in this application, and the efficiency is significantly improved compared with single-junction cells, and p-type silicon layers 1 is applied, which is cheaper than n-type silicon materials, and the use of p-type silicon materials to form laminated materials can effectively reduce production costs.

Further, the p-type silicon layer 1 comprises p-type monocrystalline silicon.

Further, the resistivity of the p-type silicon layer 1 is 0.0001~1000 ohm·cm, the resistivity of which can be 0.0001ohm·cm, 0.001ohm·cm, 0.005ohm·cm, 0.01ohm·cm, 0.05ohm·cm, 0.1ohm·cm, 0.5ohm·cm, 1ohm·cm, 10ohm·cm, 100ohm·cm, 200ohm·cm, 300ohm·cm, 400ohm·cm, 500ohm·cm, 600ohm·cm, 700ohm·cm, 800ohm·cm, 900ohm·cm or 1000ohm·cm and so on, however, this is not limited to the values listed, and other values not listed within the range of the values also apply.

Further, the thickness of the p-type silicon layer 1 is 1~500µm, the thickness of which can be 1µm, 10µm, 50µm, 100µm, 150µm, 200µm 250µm, 300µm, 350µm, 400µm, 450µm or 500µm and so on, however, this is not limited to the values listed, and other values not listed within the range of the values also apply.

Further, the material structure of the perovskite layer 2 is a three-dimensional crystal structure.

Further, the material of the perovskite layer 2 is ABX₃, wherein A comprises any one or at least two combinations of FA, MA, Cs or Rb. Wherein, A comprises any one or at least two combinations of FA, MA, Cs or Rb, B comprises any one or at least two combinations of Pb, Sn or Sr, X comprises any one or at least two combinations of Br, I or CI. Typical but non-limiting examples of the combination include: combination of FA and MA, combination of MA and Cs, combination of Cs and Rb, or combination of MA and Rb, etc. Wherein, typical but non-limiting examples of the combination include: a combination of Pb and Sn, a combination of Sn and Sr, or a combination of Pb and Sr, etc. X comprises any one or at least two combinations of Br, I or CI, wherein typical but non-limiting examples of the combination include: a combination of Br and I, a combination of I and CI, or a combination of Br and CI, etc.

Further, the thickness of the perovskite layer 2 is 10~3000nm. The thickness of the perovskite layer is 10~3000nm, and the thickness of which can be 10nm, 100nm, 200nm, 300nm, 400nm, 500nm, 600nm, 700nm, 800nm, 900nm, 1000nm, 1100nm, 1200nm, 1300nm, 1400nm, 1500nm, 1600nm, 1700nm, 1800nm, 1900nm, 2000nm , 2100nm, 2200nm, 2300nm, 2400nm, 2500nm, 2600nm, 2700nm, 2800nm, 2900nm or 3000nm and so on, however, this is not limited to the values listed, and other values not listed within the range of the values also apply.

Further, the first connecting layer 3, the second connecting layer 4 and the third connecting layer 5 respectively and independently comprises an n-type layer and/or a p-type layer.

Further, the p-type layer comprises a hole transport layer or a p-type polycrystalline silicon layer. The n-type layer comprises an electron transport layer or an n-type polycrystalline silicon layer.

Further, a quantity of p-type layers & 1, wherein the quantity may be 1, 2, 3, 4, 5 or 6, etc., but is not limited to the numerical value enumerated, and other numerical values not enumerated within the numerical range are also applicable. A quantity of n-type layers & 1, wherein the quantity may be 1, 2, 3, 4, 5 or 6, etc., but is not limited to the numerical value enumerated, and other unenumerated numerical values within the numerical range shall also apply.

Further, the material of the electron transport layer comprises any one or at least two combinations of SnOz, TiOz, ZnO, BaSnO₃, C₆₀, graphene or fullerene derivatives, wherein typical but non-limiting examples of the combination include: a combination of SnO₂ and TiO₂, a combination of TiO₂ and ZnO, a combination of ZnO and BaSnO₃, a combination of BaSnO₃ and C₆₀, combination of C₆₀ and graphene or combination of graphene and fullerene derivatives, etc..

The material of the hole transport layer comprises any one or at least two combinations of P₃HT, Spiro-meoTAD, PEDOT:PSS, Nickel oxide, PTAA, MoO₃, CuSCN, CuzO, CuI or Spiro-TTB.

Further, the thickness of the electron transport layer is 1~1000nm which does not include 0nm, and the thickness of which can be 50nm, 100nm, 150nm, 200nm, 250nm, 300nm, 350nm, 400nm, 450nm, 500nm, 550nm, 600nm, 650nm, 700nm, 750nm, 800nm, 850nm, 900nm, 950nm or 1000nm and so on, however, this is not limited to the values listed, and other values not listed within the range of the values also apply.

The thickness of the hole transport layer is 1~1000nm, the thickness of which can be 50nm, 100nm, 150nm, 200nm, 250nm, 300nm, 350nm, 400nm, 450nm, 500nm, 550nm, 600nm, 650nm, 700nm, 750nm, 800nm, 850nm, 900nm, 950nm or 1000nm and so on, however, this is not limited to the values listed, and other values not listed within the range of the values also apply.

Further, a material of the n-type polycrystalline silicon layer comprises n-type polycrystalline silicon.

Further, the thickness of the n-type polycrystalline silicon layer is 1~200nm. The thickness of the n-type polycrystalline silicon layer is 1~200nm, and the thickness of which can be 20nm, 40nm, 60nm, 80nm, 100nm, 120nm, 140nm, 160nm, 180nm or 200nm, but is not limited to the enumerated values, and other unlisted values within the numerical range are also applicable.

The n-type polysilicon in the present application adopts phosphorus-doped amorphous silicon to form polysilicon through high-temperature activation, and the p-type polysilicon adopts boron-doped amorphous silicon to form polysilicon after high-temperature activation.

Further, the first connecting layer 3, the second connecting layer 4 and the third connecting layer 5 also independently and respectively comprises any one or at least two combinations of transparent conductive electrode layer, buffer layer, tunneling layer, passivation layer or anti-reflective layer, wherein typical but non-limiting examples of the combination include: the combination of transparent conductive electrode layer and buffer layer, the combination of buffer layer and tunneling layer, the combination of tunneling layer and passivation layer or the combination of passivation layer and anti-reflection layer, etc.

Further, the material of the transparent conductive electrode layer comprises any one or at least two combinations of ITO, IZO, AZO, BZO or silver nanowires, wherein typical but non-limiting examples of the combination are: the combinations of ITO and IZO, the combinations of IZO and AZO, the combinations of AZO and BZO, or the combinations of BZO and silver nanowires, etc., but not limited to the values listed, and other values not listed within the range of such values shall also apply.

Further, the thickness of the transparent conductive electrode layer is 1~1000nm, wherein the thickness can be 50nm, 100nm, 150nm, 200nm, 250nm, 300nm, 350nm, 400nm, 450nm, 500nm, 550nm, 600nm, 650nm, 700nm, 750nm, 800nm, 850nm, 900nm, 950nm or 1000nm and so on, however, this is not limited to the values listed, and other values not listed within the range of the values also apply.

Further, the material of the buffer layer comprises SnOz and/or MoO₃.

Further, the thickness of the buffer layer is 1~1000nm, wherein the thickness can be 50nm, 100nm, 150nm, 200nm, 250nm, 300nm, 350nm, 400nm, 450nm, 500nm, 550nm, 600nm, 650nm, 700nm, 750nm, 800nm, 850nm, 900nm, 950nm or 1000nm and so on, however, this is not limited to the values listed, and other values not listed within the range of the values also apply.

Further, the material of the tunneling layer comprises any one or at least two combinations of SiOz, nc-Si:H or nc-SiO₂.

Further, the thickness of the tunneling layer is 1~100nm, wherein the thickness can be 10nm, 20nm, 30nm, 40nm, 50nm, 60nm, 70nm, 80nm, 90nm or 100nm, etc., but is not limited to the numerical value enumerated, and other unenumerated numerical values within the numerical range are also applicable.

The tunneling layer in the present application consists of at least one layer of a single substance or mixture and has the function of collecting and transmitting carriers.

As an optional technical scheme for the present application, the material of the passivation layer comprises any one or at least two combinations of PEAI, FPEAI, EDTA, PMMA, Al2O3, silicon nitride or silicon nitride, wherein typical but non-limiting examples of the combination include: a combination of PEAI and FPEAI, a combination of FPEAI and EDTA, a combination of EDTA and PMMA, a combination of PMMA and Al₂O₃, a combination of Al₂O₃ and silicon nitride or combination of silicon nitride and silicon nitride, etc..

The materials of the passivation layer in the present application independently include any one or at least two combinations of any one or at least two of the terminal functional groups such as -COOH, -OH, -NH₂, -SH, - CN, -SCN, etc. Typical but non-limiting examples of the combination include: the combination of -COOH and -OH, the combination of -OH and -NH₂, the combination of -NH₂ and -SH, the combination of -SH and -CN, or the combination of -CN and -SCN.

Further, the material of the anti-reflective layer comprises LiF and/or MgF₂.

Further, the thickness of the anti-reflective layer is 1~500nm, wherein the thickness may be 50nm, 100nm, 150nm, 200nm, 250nm, 300nm, 350nm, 400nm, 450nm or 500nm, but is not limited to the numerical value enumerated, and other unlisted numerical values within the numerical range are also applicable.

As an optional technical solution for the present application, the material of the electrode layer comprises any one or at least two combinations of silver, aluminum, gold, copper, titanium, chromium, nickel or palladium.

Further, the thickness of the electrode layer is 1~1000nm, wherein the thickness may be 50nm, 100nm, 150nm, 200nm, 250nm, 300nm, 350nm, 400nm, 450nm, 500nm, 550nm, 600nm, 650nm, 700nm, 750nm, 800nm, 850nm, 900nm, 950nm or 1000nm and so on, however, this is not limited to the values listed, and other values not listed within the range of the values also apply.

In the present application, conventional technical means such as LPCVD method, spin coating method, thermal evaporation, magnetron sputtering and other conventional technical means are selected for the preparation of solar cells, and the methods used are all conventional means which will not be further limited here.

### Embodiment 1

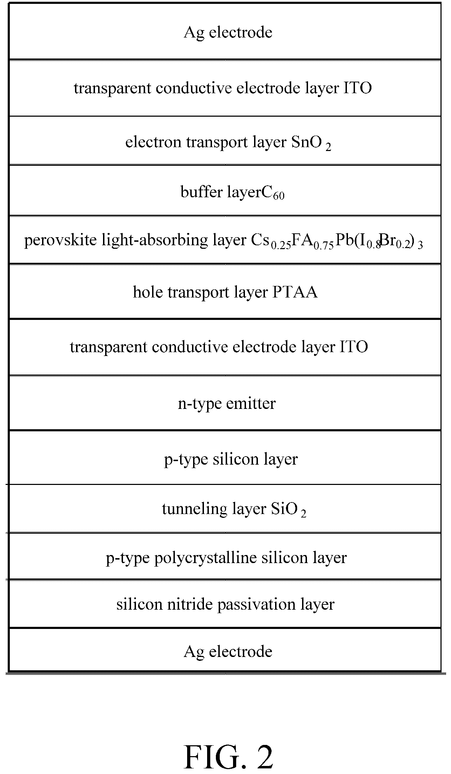

This embodiment provides a preparation method for a laminated solar cell as shown in Fig. 2:
(1) The p-type monocrystalline silicon with a thickness of 180µm is used as the substrate for conventional texturing, hydrofluoric acid and RCA standard cleaning.
(2) The diffusion furnace equipment is used to diffuse phosphorus on the front side of the monocrystalline silicon substrate to form an n-type emitter.
(3) An ultra-thin tunneling silicon oxide layer with a thickness of 1nm and a boron doped amorphous silicon layer are prepared on the back side of the monocrystalline silicon substrate by LPCVD, and activation is conducted at high temperature to form p-type polysilicon.
(4) The PECVD equipment is used to deposit a silicon nitride layer with a thickness of 75nm on p-type polysilicon.
(5) Ag electrode is formed on the back side by screen printing.
(6) A layer of 15 nm ITO is deposited on the N-type emitter by magnetron sputtering.
(7) A layer of 40nm hole transport layer PTAA is deposited on ITO by spin coating.
(8) The perovskite light-absorbing layer C_{s0.25}FA_{0.75}Pb(I_{0.8}Br_{0.2})₃ is deposited on the electron transport layer by one-step spin coating, with a band gap of about 1.68ev and a thickness of 750nm.
(9) A 5nm buffer layer of C₆₀ is deposited on the perovskite layer by spin coating.
(10) ALD equipment is used to deposit a layer of 20nm electron transport layer SnOz on the buffer layer.
(11) A layer of transparent conductive layer ITO with a thickness of 100nm is deposited on the electron transport layer by magnetron sputtering equipment.
(12) Finally, a layer of Ag electrode with a thickness of 100nm is deposited on the top by thermal evaporation equipment.

### Embodiment 2

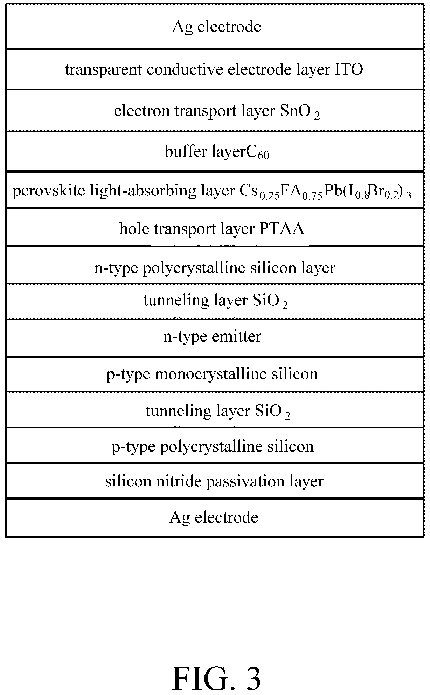

This embodiment provides a preparation method for a laminated solar cell as shown in Fig. 3:
(1) The p-type monocrystalline silicon with a thickness of 180µm is used as the substrate for conventional texturing, hydrofluoric acid and RCA standard cleaning.
(2) The diffusion furnace equipment is used to diffuse phosphorus on the front side of the monocrystalline silicon substrate to form an n-type emitter.
(3) APCVD is used to prepare a layer of ultra-thin tunneling silicon oxide with a thickness of 2nm on both sides of monocrystalline silicon.
(4) A boron-doped polycrystalline silicon layer is deposited on the ultra-thin tunneling silicon oxide layer on the front side of the monocrystalline substrate by LPCVD equipment to obtain n-type polycrystalline silicon with a thickness of 50nm; p-type polysilicon with a thickness of 150 nm is obtained by depositing a phosphorus-doped polycrystalline silicon layer on the ultra-thin tunneling silicon oxide layer on the back side of monocrystalline substrate.
(5) The PECVD equipment is used to deposit a silicon nitride layer with a thickness of 50nm on the p-type doped polycrystalline silicon layer.
(6) Ag electrode is formed on the back side by screen printing.
(7) A 30nm layer of hole transport layer PTAA is deposited on N-type polysilicon by spin coating.
(8) The perovskite light-absorbing layer C_{s0.25}FA_{0.75}Pb(I_{0.8}Br_{0.2})₃ is deposited on the electron transport layer by one-step spin coating, with a band gap of about 1.68ev and a thickness of 500nm.
(9) A 2.5nm buffer layer of C₆₀ is deposited on the perovskite layer by spin coating.
(10) ALD equipment is used to deposit a layer of 20nm electron transport layer SnOz on the buffer layer.
(11) A layer of transparent conductive layer ITO with a thickness of 100nm is deposited on the electron transport layer by magnetron sputtering equipment.
(12) Finally, a layer of Ag electrode with a thickness of 100nm is deposited on the top by thermal evaporation equipment.

### Embodiment 3

(1) A p-type monocrystalline silicon with a thickness of 180µm is used as the substrate for conventional texturing, hydrofluoric acid and RCA standard cleaning.
(2) A layer of ultra-thin tunneling silicon oxide with a thickness of 2nm is deposited on both sides of monocrystalline silicon.
(3) Using LPCVD equipment to deposit a boron-doped polycrystalline silicon layer on the ultra-thin tunneling silicon oxide on the front side of the monocrystalline substrate; a phosphorus-doped polycrystalline silicon layer with a thickness of 100 nm is deposited on the ultra-thin tunneling silicon oxide on the back side of the monocrystalline silicon substrate.
(4) PECVD equipment is used to deposit a silicon nitride layer with a thickness of 100nm on the p-type doped polycrystalline silicon layer.
(5) A layer of 50nm electron transport layer SnOz is deposited on the p-type doped polycrystalline silicon layer by spin coating.
(6) The perovskite light-absorbing layer C_{s0.25}FA_{0.75}Pb(I_{0.8}Br_{0.2})₃ is deposited on the electron transport layer by one-step spin coating, with a band gap of about 1.68ev and a thickness of 500nm.
(7) A layer of hole transport layer Spiro-meoTAD with a thickness of 200nm is deposited on the perovskite layer by spin coating.
(8) A buffer layer with a thickness of 18nm MoO₃ is deposited on the hole transport layer by thermal evaporation equipment.
(9) A layer of transparent conductive layer ITO with a thickness of 100nm is deposited on the buffer layer by magnetron sputtering equipment.
(10) Finally, a layer of Ag electrode with a thickness of 100nm is deposited on both sides of the laminated cell using thermal evaporation equipment.

The applicant declares that the above is only a specific embodiment of the present application, but the scope of protection of the present application is not limited to this, and it should be clear to those skilled in the art that any change or replacement that can be easily thought of by those skilled in the art within the scope of the technology disclosed in this application falls within the scope of protection and disclosure of this application.

## Claims

1. A laminated solar cell, **characterized in that**, the solar cell comprises a p-type silicon layer(1), a connecting layer, a perovskite layer (2) and an electrode layer, the connecting layer includes a first connecting layer (3), a second connecting layer(4) and a third connecting layer (5), and the electrode layer includes a first electrode layer (6) and a second electrode layer (7);
along a direction far away from the p-type silicon layer (1), a front side of the p-type silicon layer (1) provides the first connecting layer (3), the perovskite layer (2), the second connecting layer (4) and the first electrode layer (6) connected in turn; and a back side of the p-type silicon layer (1) provides the third connecting layer (5) and the second electrode layer (7) connected in turn.

2. The solar cell of claim 1, **characterized in that**, the p-type silicon layer (1) includes p-type monocrystalline silicon and/or p-type polycrystalline silicon.

3. The solar cell of claim 1, **characterized in that**, a resistivity of the p-type silicon layer (1) is 0.0001~1000 ohm·cm; and a thickness of the p-type silicon layer (1) is 1~500µm.

4. The solar cell of any one of claims 1∼3, **characterized in that**, a structure of a material of the perovskite layer (2) is a three-dimensional crystal structure.

5. The solar cell of claim 4, **characterized in that**, the material of the perovskite layer (2) is ABX₃, wherein A comprises any one or at least two combinations of FA, MA, Cs or Rb, B comprises any one or at least two combinations of Pb, Sn or Sr, and X comprises any one or at least two combinations of Br, I or CI.

6. The solar cell of claim 5, **characterized in that**, a thickness of the perovskite layer (2) is 10~3000nm.

7. The solar cell of any one of claims 1~6, **characterized in that**, the first connecting layer (3), the second connecting layer (4) and the third connecting layer (5) respectively and independently comprises an n-type layer and/or a p-type layer:
the p-type layer comprises a hole transport layer or a p-type polycrystalline silicon layer;
the n-type layer comprises an electron transport layer or an n-type polycrystalline silicon layer;

8. The solar cell of claim 7, **characterized in that**, a quantity of the p-type layer is ≥1; and a quantity of the n-type layer ≥ 1.

9. The solar cell of claim 7, **characterized in that**, a material of the electron transport layer comprises any one or at least two combinations of SnOz, TiOz, ZnO, BaSnO₃, C₆₀, graphene or fullerene derivatives;
a material of the hole transport layer comprises any one or at least two combinations of P₃HT, Spiro-meoTAD, PEDOT:PSS, Nickel oxide, PTAA, MoO₃, CuSCN, CuzO, CuI or Spiro-TTB.

10. The solar cell of claim 9, **characterized in that**, a thickness of the electron transport layer is 1~1000nm;
and a thickness of the hole transport layer is 1~1000nm.

11. The solar cell of claim 10, **characterized in that**, a material of the n-type polycrystalline silicon layer comprises n-type polycrystalline silicon;
and a material of the p-type polycrystalline silicon layer comprises p-type polycrystalline silicon.

12. The solar cell of claim 11, **characterized in that**, a thickness of the n-type polycrystalline silicon layer is 1~200nm;
a thickness of the p-type polycrystalline silicon layer is 1~200nm.

13. The solar cell of any one of claims 7~12, **characterized in that**, the first connecting layer (3), the second connecting layer (4) and the third connecting layer (5) also independently and respectively comprises any one or at least two combinations of transparent conductive electrode layer, buffer layer, tunneling layer, passivation layer or anti-reflection layer.

14. The solar cell of claim 13, **characterized in that**, a material of the transparent conductive electrode layer comprises any one or at least two combinations of ITO, IZO, AZO, BZO or silver nanowires;
a material of the buffer layer comprises SnOz and/or MoO₃;
a material of the tunneling layer comprises any one or at least two combinations of SiOz, nc-Si:H or nc-SiOz.

15. The solar cell of claim 14, **characterized in that**, a thickness of the transparent conductive electrode layer is 1~1000nm; a thickness of the buffer layer is 1~1000nm; a thickness of the tunneling layer is 1~100nm.

16. The solar cell of any one of claims 13∼15, **characterized in that**, a material of the passivation layer comprises any one or at least two combinations of PEAI, FPEAI, EDTA, PMMA, Al₂O₃, silicon nitride or silicon nitride; and a material of the anti-reflective layer comprises LiF and/or MgF₂.

17. The solar cell of claim 16, **characterized in that**, a thickness of the anti-reflective layer is 1~500nm.

18. The solar cell of any one of claims 1~17, **characterized in that**, a material of the electrode layer comprises any one or at least two combinations of silver, aluminum, gold, copper, titanium, chromium, nickel or palladium.

19. The solar cell of claim 18, **characterized in that**, a thickness of the electrode layer is 1~1000nm

20. An application of a laminated solar cell as claimed in any one of claims 1-19, **characterized in that**, the laminated solar cell is applied in photovoltaic field.
